# EUROPÄISCHE PATENTSCHRIFT

(11) **EP 1 581 038 B1**
(45) Veröffentlichungstag und Bekanntmachung des Hinweises auf die Patenterteilung: **04.05.2011**
(21) Anmeldenummer: 05405204.8
(22) Anmeldetag: 21.02.2005
(51) Int. Cl.: H05K 7/14

(54) **Ein- und aushebevorrichtung**
System for insertion and extraction
Dispositif pour insérer et extraire

(30) Priorität: 19.03.2004 EP 04405169
(43) Veröffentlichungstag der Anmeldung: 28.09.2005
(73) Patentinhaber: ELMA Electronic AG, 8620 Wetzikon (CH)
(72) Erfinder: Heussi, Georg, 8645 Jona (CH)
(74) Vertreter: Sulzer Management AG

(56) Entgegenhaltungen:
- DE-U- 7 724 549
- DE-U- 9 314 257
- DE-U- 20 311 072
- US-A- 4 626 823

## Beschreibung

Die Erfindung betrifft eine Ein- und Aushebevorrichtung zum Einstecken und Ausziehen einer Steckbaugruppe in beziehungsweise aus einem Baugruppenträger gemäss Oberbegriff von Anspruch 1, sowie eine Steckbaugruppe mit einer derartigen Ein- und Aushebevorrichtung und einen Baugruppenträger mit einer derartigen Steckbaugruppe.

In Baugruppenträger einführbare Steckbaugruppen weisen auf der Rückseite Mehrfachsteckverbindungen auf, deren Einsteck- und Ausziehkräfte beim Einstecken beziehungsweise Ausziehen der Steckbaugruppe überwunden werden müssen. Steckbaugruppen sind deshalb üblicherweise frontseitig mit einem unteren und/oder oberen Ein- und Aushebegriff versehen, um das Einstecken und Ausziehen zu erleichtern. Die Ein- und Aushebegriffe sind drehbar angeordnet und derart an einem frontseitigen Profil des Baugruppenträgers abgestützt, dass die Ein- und Aushebegriffe beim Einstecken und Ausziehen als Hebel wirken. Zum Einsetzen einer Steckbaugruppe müssen die Ein- und Aushebegriff voll ausgeschwenkt sein, da sie sonst das Einsetzen der Steckbaugruppe in den Baugruppenträger behindern oder gänzlich verunmöglichen. Ohne entsprechende Vorkehrungen kann die Stellung der Ein- und Aushebegriff bei einer direkten Berührung oder bei einer stärkeren Bewegung der Steckbaugruppe unbeabsichtigt ändern. Insbesondere der obere Ein- und Aushebegriff neigt dazu, auf Grund der Schwerkraft nach unten zu kippen, sodass er beim Einsetzen der Steckbaugruppe festgehalten werden muss. Zur Zeit gibt es Bestrebungen, schmal geformte, längliche Ein- und Aushebegriffe auf den Markt zu bringen, die preisgünstig hergestellt werden können. Bei derartigen Ein- und Aushebegriffen stellt sich das Problem des unbeabsichtigten Einschwenkens in besonderem Masse.

Aus Dokument DE 203 11 072 U1 ist eine Steckbaugruppe bekannt, in welcher an einem Hebelziehgriff ein Sperrhebel angelenkt ist, der den Hebelziehgriff in der ausgeschwenkten Stellung arretiert und gegen unbeabsichtigtes Verschwenken sperrt. Diese Konstruktion ist relativ aufwendig. Auch kann der Hebelziehgriff nur eingeschwenkt werden, indem gleichzeitig der Sperrhebel betätigt wird, was die Bedienung kompliziert.

Aufgabe der Erfindung ist es, eine Ein- und Aushebevorrichtung zum Einstecken und Ausziehen einer Steckbaugruppe in beziehungsweise aus einem Baugruppenträger zur Verfügung zu stellen, die gegen unbeabsichtigtes Einschwenken geschützt ist, eine einfache Bedienung aufweist und die verglichen mit Ein- und Aushebevorrichtungen aus dem Stand der Technik wirtschaftlich günstig hergestellt werden kann. Eine weitere Aufgabe der Erfindung besteht darin, eine Steckbaugruppe mit einer derartigen Ein- und Aushebevorrichtung und einen Baugruppenträger mit einer derartigen Steckbaugruppe zur Verfügung zu stellen

Diese Aufgabe wird erfindungsgemäss durch die in Anspruch 1 definierte Ein-und Aushebevorrichtung gelöst sowie durch die in Anspruch 8 definierte Steckbaugruppe und den in Anspruch 9 definierten Baugruppenträger.

Die erfindungsgemässe Ein- und Aushebevorrichtung zum Einstecken und Ausziehen einer Steckbaugruppe in beziehungsweise aus einem Baugruppenträger umfasst einen Ein- und Aushebegriff, ein Lagerelement, um welches der Ein- und Aushebegriff drehbar ist, und eine Haltevorrichtung mit mindestens einem Halteelement, um den Ein- und Aushebegriff in einer zum Einstecken der Steckbaugruppe geeigneten Stellung zu halten, vorzugsweise in einer teilweisen oder vollständig ausgeschwenkten Stellung. In der erfindungsgemässen Ein- und Aushebevorrichtung ist das Halteelement im Bereich des Lagerelements angeordnet, beispielsweise indem das Halteelement am, auf oder im Lagerelement angeordnet ist.

In einer bevorzugten Ausführungsform ist das Halteelement als Feder, insbesondere als Schenkelfeder oder Federring, oder als O-Ring ausgebildet.

In einer weiteren bevorzugten Ausführungsform ist das Lagerelement als Passschulterschraube oder als Schraube mit Hülse, beispielsweise mit entfernbarer Hülse, ausgebildet. In einer bevorzugten Ausführungsvariante ist die Breite der Schulter beziehungsweise Hülse derart dimensioniert, dass der Ein- und Aushebegriff mittels der Schraube gegen ein Bauteil der Steckbaugruppe gedrückt werden kann. In einer weiteren bevorzugten Ausführungsvariante ist die Schulter beziehungsweise Hülse zur Aufnahme eines Halteelements ausgebildet. Vorzugsweise sind auf dem Lagerelement neben dem Ein- und Aushebegriff eine Feder oder ein O-Ring angeordnet.

In einer weiteren Ausführungsvariante umfasst die Ein- und Aushebevorrichtung zusätzlich eine zweite Haltevorrichtung mit einem zweiten Halteelement, um den Ein- und Aushebegriff bei eingesetzter Steckbaugruppe in einer verriegelten Stellung, insbesondere in einer eingeschwenkten Stellung zu halten. Vorzugsweise ist das zweite Halteelement als Feder, beispielsweise als gekröpfte Blattfeder, ausgebildet und die Feder z.B. seitlich des Ein- und Aushebegriffs angeordnet.

Weiter umfasst die Erfindung eine Steckbaugruppe mit mindestens einer Ein-und Aushebevorrichtung gemäss oben stehender Beschreibung sowie einen Baugruppenträger mit einer derartigen Steckbaugruppe.

Die erfindungsgemässe Ein- und Aushebevorrichtung hat den Vorteil, dass sie in ausgeschwenkter Stellung durch die erste Haltevorrichtung gehalten wird, so dass ein unbeabsichtigtes Einschwenken beim Bewegen der Steckbaugruppe vermieden wird und das Einschwenken der Ein- und Aushebegriffe nur gegen spürbaren Widerstand möglich ist. Falls als Halteelement eine Schenkelfeder verwendet wird, bewirkt deren Federkraft, dass die Ein- und Aushebevorrichtung in die ausgeschwenkte Stellung geschwenkt wird, sobald die Steckbaugruppe aus dem Baugruppenträger herausgezogen wird. Die Anordnung des ersten Halteelements im Bereich des Lagerelements ermöglicht eine einfache und platzsparende Auslegung der Haltevorrichtung und eine kostengünstige Herstellung der Ein- und Aushebevorrichtung. Ein weiterer Vorteil der erfindungsgemässen Ein- und Aushebevorrichtung ist die einfache Bedienung derselben. Zum Einschwenken des Ein- und Aushebegriffs muss lediglich der Widerstand der Haltevorrichtung überwunden werden.

Weitere vorteilhafte Ausführungsformen gehen aus den abhängigen Ansprüchen und der Zeichnung hervor.

Im Folgenden wird die Erfindung an Hand des Ausführungsbeispiels und an Hand der Zeichnung näher erläutert. Es zeigen:
- Fig. 1: eine Schrägansicht eines Ausschnitts aus einer Steckbaugruppe mit einem Ausführungsbeispiel einer Ein- und Aushebevorrichtung gemäss vorliegender Erfindung,
- Fig. 2: den Ausschnitt von Fig. 1 von der Rückseite gesehen,
- Fig. 3: eine Detailansicht eines Schnitts durch ein Lagerelement zu dem in Fig. 1 gezeigten Ausführungsbeispiel, durch einen Ausbruch im Frontprofil der Steckbaugruppe gesehen,
- Fig. 4: eine Schrägansicht einer Ausführungsvariante einer Schenkelfeder zu dem in Fig. 1 gezeigten Ausführungsbeispiel,
- Fig. 5: eine Schrägansicht einer Ausführungsvariante einer Passschulterschraube zu dem in Fig. 1 gezeigten Ausführungsbeispiel,
- Fig. 6: eine Schrägansicht einer Ausführungsvariante eines Frontprofils zu der in Fig. 1 gezeigten Steckbaugruppe,
- Fig. 7: eine Schrägansicht eines Ausschnitts aus einer Steckbaugruppe mit einem zweiten Ausführungsbeispiel einer Ein- und Aushebevorrichtung gemäss vorliegender Erfindung, und
- Fig. 8: eine Detailansicht eines Schnitts durch ein Lagerelement zu dem in Fig. 7 gezeigten Ausführungsbeispiel, durch einen Ausbruch im Frontprofil der Steckbaugruppe gesehen.

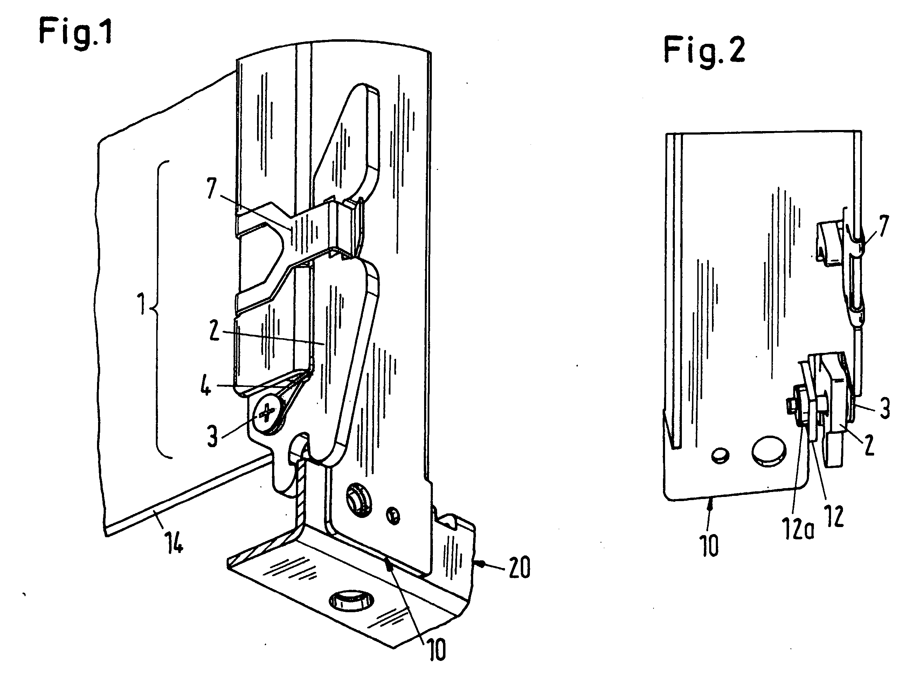

Fig. 1 zeigt eine Schrägansicht eines Ausschnitts aus einer Steckbaugruppe mit einem Ausführungsbeispiel einer Ein- und Aushebevorrichtung 1 gemäss vorliegender Erfindung. Die Ein- und Aushebevorrichtung umfasst einen Ein-und Aushebegriff 2 und ein Lagerelement 3, um welches der Ein- und Aushebegriff drehbar ist, und das beispielsweise als Passschulterschraube oder als Schraube mit Hülse ausgebildet sein kann. Weiter umfasst die Ein-und Aushebevorrichtung 1 eine Haltevorrichtung mit mindestens einem Halteelement 4, das in dem in Fig. 1 gezeigten Ausführungsbeispiel als Schenkelfeder ausgebildet ist, die im Bereich des Lagerelements 3 angeordnet ist und dieses beispielsweise umschliesst.

Weiter ist in dem in Fig. 1 gezeigten Ausschnitt ein Frontprofil 10 und eine Leiterplatte 14 einer Steckbaugruppe dargestellt sowie ein Frontprofil 20 eines Baugruppenträgers, in den die Steckbaugruppe eingesetzt ist. Die Ein- und Aushebevorrichtung 1 ist im unteren Bereich des Frontprofils 10 der Steckbaugruppe an dieser befestigt, derart, dass der zugehörige Ein- und Aushebegriff 2 nach vorne ausgeschwenkt werden kann und in eingeschwenkter Stellung desselben das Frontprofil 20 des Baugruppenträgers in eine Einbuchtung des Ein- und Aushebegriffs eingreift. Beim Ausschwenken des Ein- und Aushebegriffs 2 stützt sich dieser am Frontprofil 20 des Baugruppenträgers ab, wodurch die Steckbaugruppe aus dem Baugruppenträger gezogen wird. Umgekehrt kann beim Einsetzen der Steckbaugruppe durch Einschwenken des Ein- und Aushebegriffs 2 die Steckbaugruppe in entsprechender Weise in den Baugruppenträger eingeschoben werden.

In einer Ausführungsvariante umfasst die Ein- und Aushebevorrichtung 1 zusätzlich eine zweite Haltevorrichtung mit einem zweiten Halteelement 7, um den Ein- und Aushebegriff 2 bei eingesetzter Steckbaugruppe in einer eingeschwenkten Stellung zu halten und/oder zu verriegeln. Das zweite Halteelement kann als Feder, beispielsweise wie in Fig. 1 dargestellt als gekröpfte Blattfeder, ausgebildet sein, die z.B. seitlich des Ein- und Aushebegriffs angeordnet ist.

Fig. 2 zeigt den in Fig. 1 dargestellten Ausschnitt aus einer Steckbaugruppe von der Rückseite gesehen. Die Bezugsnummern von Fig. 1 wurden beibehalten. Von der Ein- und Aushebevorrichtung ist in Fig. 2 insbesondere der Ein- und Aushebegriff 2, das Lagerelement 3 und der rückwärtige Teil des zweiten Halteelements 7 sichtbar. Von der Steckbaugruppe ist darüber hinaus das Frontprofil 10 und ein Befestigungsteil 12 sichtbar, das im Ausführungsbeispiel am Frontprofil angebracht ist und beispielsweise als eingeklinkte Lasche des Frontprofils ausgebildet sein kann. Vorteilhafterweise weist das Befestigungsteil eine Öffnung auf, z.B. eine Öffnung mit Kragen oder eine eingepresste Buchse, in die das Lagerelement 3 eingesetzt, eingepresst oder eingeschraubt werden kann. In Fig. 2 ist die in Fig. 1 gezeigte Leiterplatte 14 nicht dargestellt, da sie einen grösseren Teil der Fig. 2 abdecken würde. Dafür ist der Ein- und Aushebegriff 2 in Fig. 2 beabstandet vom Befestigungsteil 12 dargestellt, um anzudeuten, dass an dieser Stelle eine Leiterplatte eingefügt werden kann.

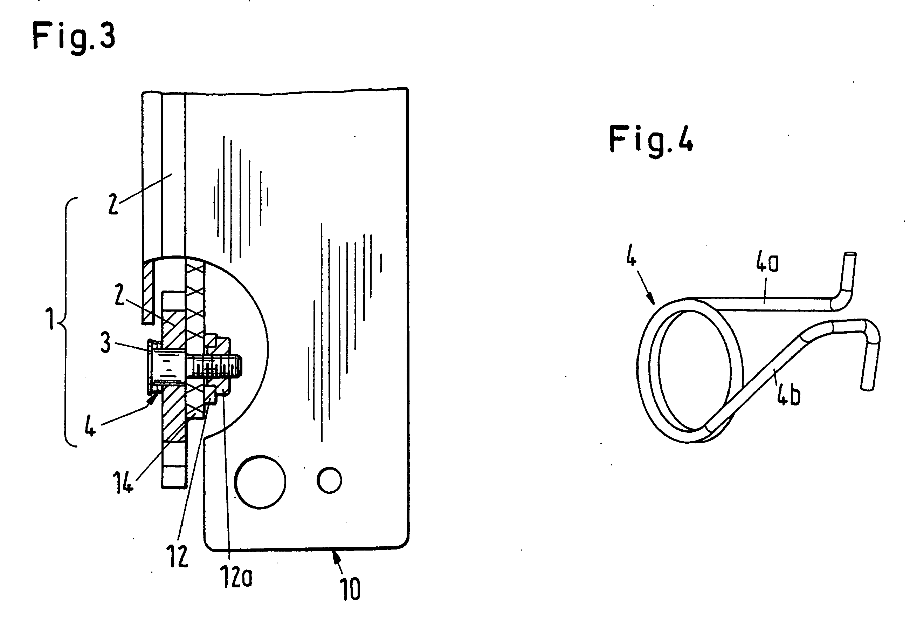

Fig. 3 zeigt eine Detailansicht eines Schnitts durch ein Lagerelement 3 zu dem in Fig. 1 gezeigten Ausführungsbeispiel. Im Frontprofil 10 der Steckbaugruppe ist an der entsprechenden Stelle ein (in Wirklichkeit nicht vorhandener) Ausbruch eingezeichnet, um die Sicht auf den Schnitt freizugeben. Die Ein- und Aushebevorrichtung 1 umfasst einen Ein- und Aushebegriff 2, ein Lagerelement 3, das beispielsweise als Passschulterschraube oder als Schraube mit Hülse ausgebildet sein kann und ein Halteelement 4, das z.B. als Feder ausgebildet sein kann, beispielsweise als Schenkelfeder, Spiralfeder mit Schenkeln oder als Federring. Die Steckbaugruppe umfasst weiter ein Befestigungsteil 12 mit einer Öffnung 12a, insbesondere mit einem Gewindeteil, um das Lagerelement 3 zu befestigen, und eine Leiterplatte 14, die vorteilhafterweise mit dem Lagerelement 3 am Befestigungsteil 12 befestigt ist, beispielsweise indem das Lagerelement mit einer Schulter versehen ist, mittels welcher die Leiterplatte an das Befestigungsteil 12 angedrückt wird.

Fig. 4 zeigt eine Schrägansicht einer Ausführungsvariante einer Schenkelfeder 4, wie sie z.B. in dem in Fig. 1 gezeigten Ausführungsbeispiel verwendet wird. Die Schenkelfeder 4 umfasst vorzugsweise mindestens eine Windung einer Schraubenfeder sowie zwei Schenkel 4a, 4b, die an Ihrem äusseren Ende abgebogen beziehungsweise abgekröpft sein können. Im Ausführungsbeispiel von Fig. 1 ist das abgekröpfte Ende des einen Schenkels am Hebel 2 verankert, während das abgebogene Ende des andern Schenkels am Frontprofil 10 der Steckbaugruppe abgestützt ist.

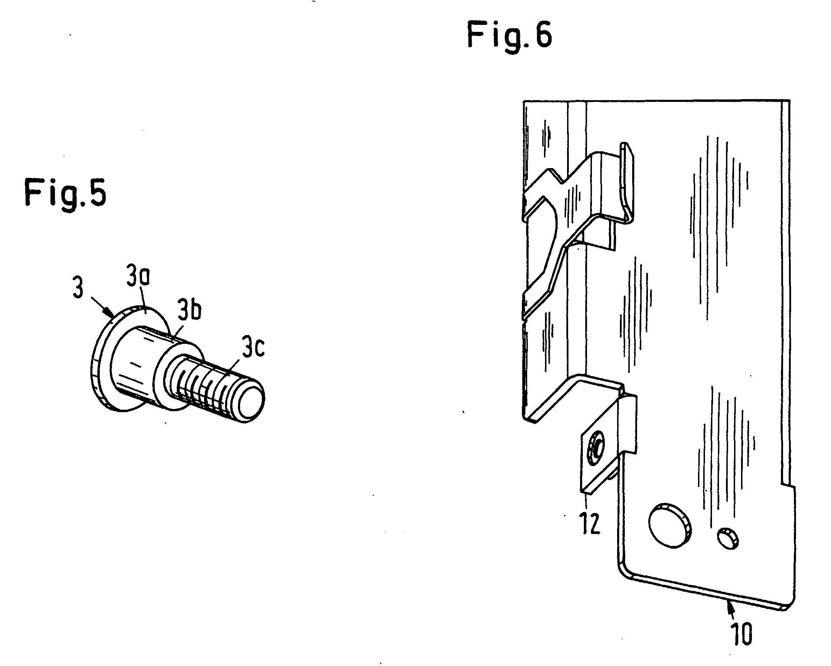

In der in Fig. 5 gezeigten Ausführungsvariante einer Passschulterschraube umfasst diese einen Schraubenkopf 3a, eine Schulter 3b und einen Gewindeteil 3c, welche koaxial aneinandergereiht angeordnet sind, wobei der Schraubenkopf den grössten Durchmesser, die Schulter einen mittleren und der Gewindeteil den kleinsten Durchmesser aufweisen. Mit Vorteil ist die Schulter zur Aufnahme des Halteelements ausgebildet, sodass auf der Schulter neben dem Ein- und Aushebegriff ein Halteelement, beispielsweise eine Feder oder ein O-Ring, angeordnet werden kann. In einer bevorzugten Ausführungsvariante ist die Breite der Schulter derart dimensioniert, dass der Ein- und Aushebegriff mittels der Schraube gegen ein Bauteil, beispielsweise gegen einen Befestigungsteil 12 oder eine Leiterplatte 14 der Steckbaugruppe gepresst werden kann. In einer weiteren bevorzugten Ausführungsvariante, die beispielsweise in dem in den Figuren 1 und 3 gezeigten Ausführungsbeispiel verwendet werden kann, ist die Windung einer Schraubenfeder 4 mit Schenkeln und der Ein- und Aushebegriff 2 auf der Schulter angeordnet, und die Breite der Schulter ist derart dimensioniert, dass der Ein- und Aushebegriff mittels der Schraubenfeder ausgeschwenkt werden kann.

Fig. 6 zeigt eine Schrägansicht einer bevorzugten Ausführungsvariante eines Frontprofils zu der in Fig. 1 gezeigten Steckbaugruppe. Das Frontprofil 10 umfasst in dieser Ausführungsvariante einen Befestigungsteil 12, der mit dem Frontprofil verbunden ist und zur Befestigung eines Lagerelements, beispielsweise einer Passschulterschraube der oben beschriebenen Ein- und Aushebevorrichtung dient. Das Befestigungsteil 12 kann beispielsweise als eingeklinkte Lasche des Frontprofils 10 ausgebildet sein.

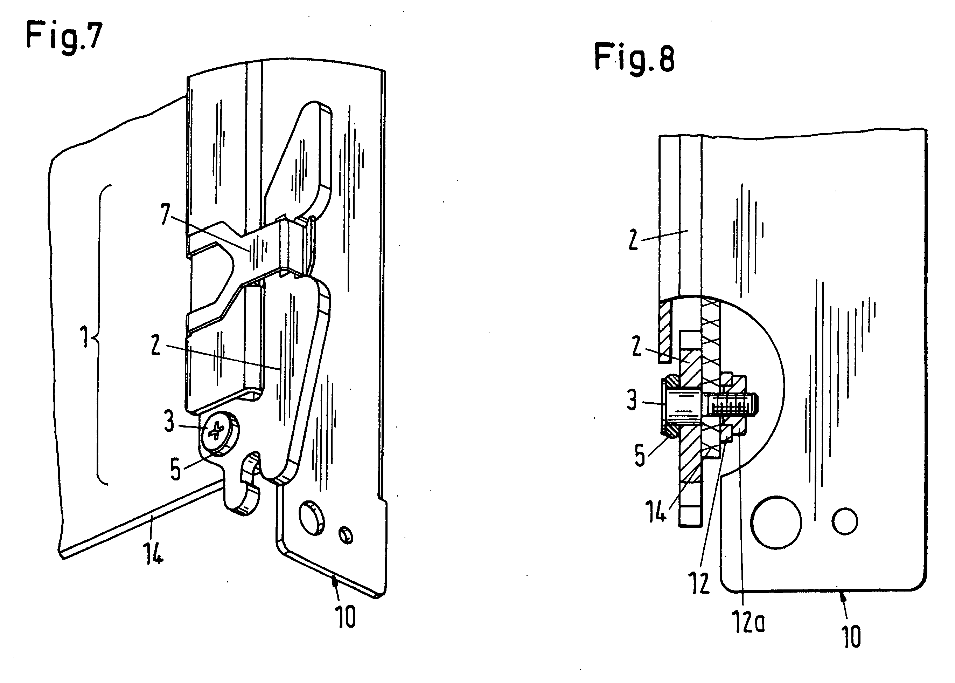

Fig. 7 zeigt eine Schrägansicht eines Ausschnitts aus einer Steckbaugruppe mit einem zweiten Ausführungsbeispiel einer Ein- und Aushebevorrichtung 1 gemäss vorliegender Erfindung. Die Ein- und Aushebevorrichtung umfasst im zweiten Ausführungsbeispiel einen Ein- und Aushebegriff 2 und ein Lagerelement 3, um welches der Ein- und Aushebegriff drehbar ist, und das beispielsweise als Passschulterschraube oder als Schraube mit Hülse ausgebildet sein kann. Weiter umfasst die Ein- und Aushebevorrichtung 1 eine Haltevorrichtung mit mindestens einem Halteelement 5, das im zweiten Ausführungsbeispiel als O-Ring ausgebildet ist, der auf dem Lagerelement 3 angeordnet ist. Bedarfsweise umfasst die Ein- und Aushebevorrichtung 1 zusätzlich eine zweite Haltevorrichtung mit einem zweiten Halteelement 7, um den Ein- und Aushebegriff 2 bei eingesetzter Steckbaugruppe in einer eingeschwenkten Stellung zu halten und/oder zu verriegeln. Weiter ist in dem in Fig. 7 gezeigten Ausschnitt ein Frontprofil 10 und eine Leiterplatte 14 einer Steckbaugruppe dargestellt.

Fig. 8 zeigt eine Detailansicht eines Schnitts durch ein Lagerelement 3 zu dem in Fig. 7 gezeigten Ausführungsbeispiel. Im Frontprofil 10 der Steckbaugruppe ist an der entsprechenden Stelle ein (in Wirklichkeit nicht vorhandener) Ausbruch eingezeichnet, um die Sicht auf den Schnitt freizugeben. Die Ein- und Aushebevorrichtung 1 umfasst einen Ein- und Aushebegriff 2, ein Lagerelement 3, das beispielsweise als Passschulterschraube oder als Schraube mit Hülse ausgebildet sein kann und ein Halteelement 5, das in diesem Ausführungsbeispiel als O-Ring ausgebildet ist. Die Steckbaugruppe umfasst weiter ein Befestigungsteil 12 mit einer Öffnung 12a, insbesondere mit einem Gewindeteil, um das Lagerelement 3 zu befestigen, und eine Leiterplatte 14, die vorteilhafterweise mit dem Lagerelement 3 am Befestigungsteil 12 befestigt ist, beispielsweise indem das Lagerelement mit einer Schulter versehen ist, mittels welcher die Leiterplatte an das Befestigungsteil 12 angedrückt wird. Vorteilhafterweise ist die Breite der Schulter derart dimensioniert, dass der Ein- und Aushebegriff 2 mittels des Lagerelements gegen ein Bauteil der Steckbaugruppe gepresst werden kann.

Die Anordnung des ersten Halteelements im Bereich des Lagerelements hat den Vorteil, dass die Haltevorrichtung einfach und platzsparend ausgelegt werden kann, und ermöglicht eine kostengünstige Herstellung der Ein- und Aushebevorrichtung. Der Umstand, dass das Lagerelement gleichzeitig mehrere Funktionen erfüllen kann, z.B. als Lager für den Ein- und Aushebegriff, als Befestigungselement für eine Leiterplatte oder als Anpress-und/oder Zentrierteil für die Haltevorrichtung, wirkt ebenfalls Kosten senkend. Ein weiterer Vorteil der erfindungsgemässen Ein- und Aushebevorrichtung ist die einfache Bedienung derselben, indem zum Einschwenken des Ein- und Aushebegriffs lediglich der Widerstand der Haltevorrichtung überwunden werden muss.

## Patentansprüche

1. Ein- und Aushebevorrichtung zum Einstecken und Ausziehen einer Steckbaugruppe in beziehungsweise aus einem Baugruppenträger, welche Ein- und Aushebevorrichtung (1) einen Ein- und Aushebegriff (2), ein Lagerelement (3), um welches der Ein- und Aushebegriff (2) drehbar ist, und eine Haltevorrichtung mit mindestens einem Halteelement (4, 5) umfasst, um den Ein- und Aushebegriff (2) in einer zum Einstecken der Steckbaugruppe geeigneten Stellung zu halten, **dadurch gekennzeichnet, dass** das Halteelement (4, 5) im Bereich des Lagerelements (3) angeordnet ist, wobei das Lagerelement als Passschulterschraube mit Schulter (3b) oder als Schraube mit Hülse, ausgebildet ist.

2. Ein- und Aushebevorrichtung nach Anspruch 1, wobei das Halteelement (4, 5) als Feder (4), insbesondere als Schenkelfeder oder Federring, oder als O-Ring (5) ausgebildet ist, und die Feder oder der O-Ring im Bereich des Lagerelementes (3) oder am oder auf dem Lagerelement (3) angeordnet sind.

3. Ein- und Aushebevorrichtung nach einem der Ansprüche 1 oder 2, wobei die Breite der Schulter (3b) beziehungsweise Hülse derart ausgebildet ist, dass der Ein- und Aushebegriff (2) mittels der Passschulterschraube gegen ein Bauteil (12, 14) der Steckbaugruppe drückbar ist.

4. Ein- und Aushebevorrichtung nach einem der Ansprüche 1 oder 2, wobei die Schulter (3b) beziehungsweise Hülse zur Aufnahme eines Halteelements (4, 5) ausgebildet ist.

5. Ein- und Aushebevorrichtung nach einem der Ansprüche 1 bis 4, wobei auf dem Lagerelement (3) neben dem Ein- und Aushebegriff (2) eine Feder (4) oder ein O-Ring (5) angeordnet sind.

6. Ein- und Aushebevorrichtung nach einem der Ansprüche 1 bis 5 umfassend zusätzlich eine zweite Haltevorrichtung mit einem zweiten Halteelement (7), um den Ein- und Aushebegriff (2) bei eingesetzter Steckbaugruppe in einer verriegelten Stellung zu halten.

7. Ein- und Aushebevorrichtung nach Anspruch 6, wobei das zweite Halteelement (7) als Feder, insbesondere als gekröpfte Blattfeder ausgebildet ist, und wobei die Feder in montiertem Zustand insbesondere seitlich des Ein- und Aushebegriffs angeordnet ist.

8. Steckbaugruppe umfassend mindestens eine Ein- und Aushebevorrichtung (1) nach einem der Ansprüche 1 bis 7.

9. Baugruppenträger umfassend mindestens eine Steckbaugruppe nach Anspruch 8.

## Claims

1. An installation and withdrawal apparatus for the plugging in and removal of a plug-in assembly into or out of an assembly support which installation and withdrawal apparatus (1) includes an installation and withdrawal handle (2), a bearing element (3) about which the installation and withdrawal handle (2) is rotatable and a holding apparatus having at least one holding element (4, 5) in order to hold the installation and withdrawal handle (2) in a position suitable for the plugging in of the plug-in assembly, **characterised in that** the holding element (4, 5) is arranged in the region of the bearing element (3), wherein the bearing element (3) is made as a fitting shoulder screw having a shoulder (3b) or as a screw with a sleeve.

2. An installation and withdrawal apparatus in accordance with claim 1, wherein the holding element (4, 5) is made as a spring (4), in particular as a leg spring or as a spring ring, or as an O ring (5), and the spring or the O ring is arranged in the region of the bearing element (3) or at or on the bearing element (3).

3. An installation and withdrawal apparatus in accordance with one of claims 1 or 2, wherein the width of the shoulder (3b) or sleeve is formed such that the installation and withdrawal handle (2) can be pressed towards a component (12, 14) of the plug-in assembly by means of the fitting shoulder screw.

4. An installation and withdrawal apparatus in accordance with one of claims 1 or 2, wherein the shoulder (3b) or sleeve is made for the reception of a holding element (4, 5).

5. An installation and withdrawal apparatus in accordance with one of claims 1 to 4, wherein a spring (4) or an O ring (5) is arranged on the bearing element (3) in addition to the installation and withdrawal handle (2).

6. An installation and withdrawal apparatus in accordance with one of claims 1 to 5, additionally including a second holding apparatus having a second holding element (7) to hold the installation and withdrawal handle (2) in a latched position, when the plug-in assembly is inserted.

7. An installation and withdrawal apparatus in accordance with claim 6, wherein the second holding element (7) is made as a spring, in particular as a cranked leaf spring, and wherein the spring is in particular arranged to the side of the installation and withdrawal handle in the assembled state.

8. A plug-in assembly including at least one installation and withdrawal apparatus (1) in accordance with one of claims 1 to 7.

9. An assembly support including at least one plug-in assembly in accordance with claim 8.

## Revendications

1. Dispositif d'insertion et d'extraction pour l'enfichage et l'extraction d'un module à enficher dans ou hors d'un porte-module, lequel dispositif d'insertion et d'extraction (1) comporte une poignée d'insertion et d'extraction (2), un élément de palier (3), autour duquel peut tourner la poignée d'insertion et d'extraction (2), et un dispositif de retenue avec au moins un élément de retenue (4, 5), destiné à maintenir la poignée d'insertion et d'extraction (2) dans une position appropriée pour l'enfichage du module à enficher, **caractérisé en ce que** l'élément de retenue (4, 5) est disposé dans la zone de l'élément de palier (3), ledit élément de palier (3) étant réalisé sous la forme d'une vis d'ajustement épaulée avec un épaulement (3b) ou sous la forme d'une vis à douille.

2. Dispositif d'insertion et d'extraction selon la revendication 1, dans lequel l'élément de retenue (4, 5) est réalisé sous la forme d'un ressort (4), en particulier un ressort à branches ou une rondelle-ressort, ou sous la forme d'un joint torique (5), et le ressort ou le joint torique sont disposés dans la zone de l'élément de palier (3) ou bien contre ou sur l'élément de palier (3).

3. Dispositif d'insertion et d'extraction selon la revendication 1 ou 2, dans lequel la largeur de l'épaulement (3b) ou de la douille est réalisée de telle sorte que la poignée d'insertion et d'extraction (2) peut être poussée, au moyen de la vis d'ajustement épaulée, contre un élément (12, 14) du module à enficher.

4. Dispositif d'insertion et d'extraction selon la revendication 1 ou 2, dans lequel l'épaulement (3b) ou la douille est réalisé pour recevoir un élément de retenue (4, 5).

5. Dispositif d'insertion et d'extraction selon l'une quelconque des revendications 1 à 4, dans lequel un ressort (4) ou un joint torique (5) sont disposés sur l'élément de palier (3) à côté de la poignée d'insertion et d'extraction (2).

6. Dispositif d'insertion et d'extraction selon l'une quelconque des revendications 1 à 5, comportant, en outre, un deuxième dispositif de retenue avec un deuxième élément de retenue (7), destiné à maintenir la poignée d'insertion et d'extraction (2) dans une position verrouillée lorsque le module à enficher est inséré.

7. Dispositif d'insertion et d'extraction selon la revendication 6, dans lequel le deuxième élément de retenue (7) est réalisé sous la forme d'un ressort, en particulier un ressort à lame coudé, et ledit ressort, à l'état monté, étant disposé en particulier latéralement de la poignée d'insertion et d'extraction.

8. Module à enficher comportant au moins un dispositif d'insertion et d'extraction (1) selon l'une quelconque des revendications 1 à 7.

9. Porte-module comportant au moins un module à enficher selon la revendication 8.
